# EUROPEAN PATENT APPLICATION

(11) **EP 4 773 335 A1**
(43) Date of publication of application: **08.07.2026**
(21) Application number: 25219859.3
(22) Date of filing: 01.12.2025
(51) Int. Cl.: H01M 10/48

(54) **METHOD FOR DETECTING FIRE IN BATTERIES USING CLOUD SERVICES**

(30) Priority: 26.12.2024 KR 20240197788
(71) Applicant: SAMSUNG SDI CO., LTD., Yongin-si, Gyeonggi-do 17084 (KR)
(72) Inventor: LEE, Jihoon, 17084 Yongin-si (KR)
(74) Representative: Marks & Clerk LLP

(57) **Abstract**

Disclosed herein is a method for detecting fire in ESSs using cloud services. The method for detecting fire in ESSs includes receiving battery status data from battery management systems via a server, and analyzing the received battery status data to determine whether a fire occurs. It is possible to detect whether a fire has occurred in an ESS without installing a separate fire sensor in the ESS.

## Description

### BACKGROUND

### 1. Technical Field

The present disclosure relates to a method for detecting fire in batteries using cloud services.

### 2. Related Art

Energy storage systems (ESSs) are systems that are able to store surplus electricity or electricity produced using renewable energy. The ESSs are usable to smoothly control power supply and demand by storing idle power during times of low electricity demand and then supplying it during times of high electricity demand.

ESSs may be burned during operation, wherein if a fire in the ESSs is not extinguished in the early stages thereof, it is difficult to extinguish the fire. Therefore, it is necessary to detect whether a fire has occurred in ESSs at an early stage.

Whether a fire has occurred in ESSs may be detected using additional sensors such as smoke sensors, but it is difficult to recognize the occurrence of fire with those sensors if their batteries are discharged or broken. In particular, ESSs are often operated unmanned in remote locations, making it difficult to check whether there is a fire in the early stages thereof.

The above information disclosed in this Background section is for enhancement of understanding of the background of the present disclosure, and therefore, it may contain information that does not constitute a prior art.

### SUMMARY

Accordingly, an object of the present disclosure is to provide a method for early detection of whether a fire has occurred in an ESS or battery pack. Another object of the present disclosure is to provide a method for early detection of an occurrence of fire even when a fire sensor is not installed on site.

In accordance with an aspect of the present disclosure, there is provided a method for detecting fire in ESSs, which includes receiving battery status data from battery management systems via a server, and analyzing the received battery status data to determine whether a fire occurs.

In the analyzing the received battery status data, it may be determined that the fire occurs if a cell voltage drops over a predetermined period of time, a voltage deviation between cells is maintained over a predetermined period of time, and a minimum cell voltage within a rack is lower than a threshold voltage.

In the analyzing the received battery status data, it may be determined that the fire occurs if the following three conditions are all satisfied: a cell voltage drops over a predetermined period of time; a voltage deviation between cells is maintained over a predetermined period of time; and a minimum cell voltage within a rack is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a rack BMS and a module BMS is generated; a protective action is performed because the communication error occurs between the rack BMS and the module BMS; and a module BMS PCB temperature is maintained above a certain value.

In the analyzing the received battery status data, it may be determined that the fire occurs if at least two of the following three conditions are satisfied: a cell voltage drops over a predetermined period of time, a voltage deviation between cells is maintained over a predetermined period of time, and a minimum cell voltage within a rack is lower than a threshold voltage.

In the analyzing the received battery status data, it may be determined that the fire occurs if at least two of the following three conditions are satisfied: a cell voltage drops over a predetermined period of time; a voltage deviation between cells is maintained over a predetermined period of time; and a minimum cell voltage within a rack is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a rack BMS and a module BMS is generated; a protective action is performed because the communication error occurs between the rack BMS and the module BMS; and a module BMS PCB temperature is maintained above a certain value.

In the analyzing the received battery status data, it may be determined that the fire occurs if a minimum cell voltage within a rack is lower than a threshold voltage, a current measured in the rack is lower than a threshold current, a maximum module temperature within the rack is higher than a threshold temperature, and the minimum cell voltage within the rack being lower than the threshold voltage and the maximum module temperature within the rack being higher than the threshold temperature occur in the same module.

The method for detecting fire in ESSs may further include notifying that a fire event occurs if it is determined that the fire occurs.

The server may be a cloud server.

In accordance with another aspect of the present disclosure, there is provided a method for detecting fire in battery packs, which includes receiving battery status data from battery management systems via a server, and analyzing the received battery status data to determine whether a fire occurs.

In the analyzing the received battery status data, it may be determined that the fire occurs if a cell voltage drops over a predetermined period of time, a voltage deviation between cells is maintained over a predetermined period of time, and a minimum cell voltage within a battery pack is lower than a threshold voltage.

In the analyzing the received battery status data, it may be determined that the fire occurs if the following three conditions are all satisfied: a cell voltage drops over a predetermined period of time; a voltage deviation between cells is maintained over a predetermined period of time; and a minimum cell voltage within a battery pack is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a battery pack BMS and a module BMS is generated; a protective action is performed because the communication error occurs between the battery pack BMS and the module BMS; and a module BMS PCB temperature is maintained above a certain value.

In the analyzing the received battery status data, it may be determined that the fire occurs if at least two of the following three conditions are satisfied: a cell voltage drops over a predetermined period of time, a voltage deviation between cells is maintained over a predetermined period of time, and a minimum cell voltage within a battery pack is lower than a threshold voltage.

In the analyzing the received battery status data, it may be determined that the fire occurs if at least two of the following three conditions are satisfied: a cell voltage drops over a predetermined period of time; a voltage deviation between cells is maintained over a predetermined period of time; and a minimum cell voltage within a battery pack is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a battery pack BMS and a module BMS is generated; a protective action is performed because the communication error occurs between the battery pack BMS and the module BMS; and a module BMS PCB temperature is maintained above a certain value.

In the analyzing the received battery status data, it may be determined that the fire occurs if a minimum cell voltage within a battery pack is lower than a threshold voltage, a current measured in the battery pack is lower than a threshold current, a maximum module temperature within the battery pack is higher than a threshold temperature, and the minimum cell voltage within the battery pack being lower than the threshold voltage and the maximum module temperature within the battery pack being higher than the threshold temperature occur in the same module.

The method for detecting fire in battery packs may further include notifying that a fire event occurs if it is determined that the fire occurs.

The server may be a cloud server.

At least some of the above and other features of the invention are set out in the claims.

### BRIEF DESCRIPTION OF THE DRAWINGS

The following drawings attached to this specification illustrate preferred embodiments of the present disclosure, and help to further understand the technical scope of the present disclosure along with the aforementioned contents of the disclosure. Accordingly, the present disclosure should not be construed as being limited to only contents described in such drawings:
FIG. 1 schematically illustrates an electrode assembly of a secondary battery;
FIG. 2 schematically illustrates a pouch-type secondary battery;
FIG. 3 is a top perspective view illustrating an exterior of a prismatic battery;
FIG. 4 is a cross-sectional view of a cylindrical secondary battery;
FIG. 5 is a conceptual diagram for explaining a method for detecting fire in ESSs or battery packs using cloud services according to the present disclosure;
FIG. 6 is a flow diagram illustrating a procedure for determining whether there is a fire event according to an embodiment of the present disclosure;
FIG. 7 is a flow diagram illustrating a fire event occurrence determination algorithm according to the embodiment of the present disclosure;
FIG. 8 is a flow diagram illustrating a fire event occurrence determination algorithm according to another embodiment of the present disclosure;
FIG. 9 is a flow diagram illustrating a procedure for determining whether there is a fire event according to another embodiment of the present disclosure;
Figure 10 is a block diagram showing a computer system for implementing a method according to embodiments of the present disclosure.
FIG. 11 is a view of a secondary battery module in which secondary batteries are arranged according to one or more embodiments of the present disclosure;
FIG. 12 is a view of a secondary battery pack including the secondary battery module illustrated in FIG. 11; and
FIG. 13 is a conceptual view of a vehicle including the secondary battery pack illustrated in FIG. 12.

### DETAILED DESCRIPTION

Example embodiments of the present disclosure will be described below in detail with reference to the accompanying drawings. Prior to the description, it is noted that the terms or words used in this specification and claims should not be construed as being limited to common or dictionary meanings but instead should be understood to have meanings and concepts in agreement with the scope of the present disclosure based on the principle that an inventor can define the concept of each term suitably in order to describe his/her own invention in the best way possible. Accordingly, since the embodiments described in this specification and the configurations illustrated in the drawings are only an example of the present disclosure and they do not cover all the technical ideas of the present disclosure, it should be understood that various changes and modifications may be made at the time of filing this application.

It will be further understood that the terms "comprises/includes" and/or "comprising/including" when used herein, specify the presence of stated features, integers, steps, operations, elements, components, and/or groups thereof, but do not preclude the presence or addition of one or more other features, integers, steps, operations, elements, components, and/or groups thereof.

In order to facilitate understanding of the present disclosure, the accompanying drawings are not drawn to scale and the dimensions of some components may be exaggerated. It should be noted that the same reference numerals are designated to the same components in different embodiments.

Reference to two compared elements, features, etc. as being "the same" means that they are "substantially the same". Therefore, the phrase "substantially the same" may include a deviation that is considered low in the art, for example, a deviation of 5% or less. The uniformity of any parameter in a given region may mean that it is uniform from an average perspective.

Although the terms such as "first" and/or "second" are used to describe various components, these components are not limited by these terms, of course. These terms are only used to distinguish one component from another component. Thus, unless specifically stated to the contrary, a first component may be termed a second component without departing from the teachings of example embodiments.

Throughout the specification, unless otherwise stated, each element may be singular or plural.

Arrangement of any component "above (or below)" or "on (or under)" a component may mean that any component is disposed in contact with the upper (or lower) surface of the component, as well as that other components may be interposed between the element and any element disposed on (or under) the element.

It will be understood that, when a component is referred to as being "connected", "coupled", or "joined" to another component, not only can it be directly "connected", "coupled", or "joined" to the other element, but also can it be indirectly "connected", "coupled", or "joined" to the other element with other elements interposed therebetween.

As used herein, the term "and/or" includes any and all combinations of one or more of the associate listed items. The use of "may" when describing embodiments of the present disclosure relates to "one or more embodiments of the present disclosure". Expressions such as "at least one" and "one or more" preceding a list of elements modify the entire list of elements and do not modify the individual elements in the list.

Throughout the specification, when "A and/or B" is stated, it means A, B, or A and B, unless otherwise stated. In addition, when "C to D" is stated, it means C or more and D or less, unless specifically stated to the contrary.

When the phrase such as "at least one of A, B, and C", "at least one of A, B, or C", "at least one selected from the group of A, B, and C", or "at least one selected from among A, B, and C" is used to designate a list of elements A, B, and C, the phrase may refer to any and all suitable combinations.

The term "use" may be considered synonymous with the term "utilize". As used herein, the terms "substantially," "about," and similar terms are used as terms of approximation rather than as terms of degree, and are intended to account for inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Accordingly, a first element, component, region, layer, or section discussed below may be termed a second element, component, region, layer, or section without departing from the teachings of example embodiments.

For ease of explanation in describing the relationship of one element or feature to another element(s) or feature(s) as illustrated in the drawings, spatially relative terms such as "beneath", "below", "lower", "above", and "upper" may be used herein. It will be understood that spatially relative positions are intended to encompass different directions of the device in use or operation in addition to the direction depicted in the drawings. For example, if the device in the drawings is turned over, any element described as being "below" or "beneath" another element would then be oriented "above" or "over" another element. Therefore, the term "below" may encompass both upward and downward directions.

The terminology used herein is for the purpose of describing embodiments of the present disclosure and is not intended to limit the present disclosure.

A battery pack according to one or more embodiments includes at least one battery module and a pack housing having an accommodation space in which the at least one battery module is accommodated.

The battery module may include a plurality of battery cells and a module housing. The battery cells may be accommodated inside the module housing in a stacked form (or stacked arrangement or configuration). Each battery cell may have a positive electrode terminal and a negative electrode terminal and may be a circular type, a prismatic type, or a pouch type according to the shape of battery. In the present specification, a battery cell may also be referred to as a secondary battery, a battery, or a cell.

In the battery pack, one cell stack may constitute one module stacked in place of the battery module. The cell stack may be accommodated in an accommodation space of the pack housing or may be accommodated in an accommodation space partitioned by a frame, a partition wall, etc.

The battery cell may generate a large amount of heat during charging/discharging. The generated heat may be accumulated in the battery cell, thereby accelerating the deterioration of the battery cell. Accordingly, the battery pack may further include a cooling member to remove the generated heat and thereby suppress deterioration of the battery cell. The cooling member may be provided at the bottom of the accommodation space at where the battery cell is provided but is not limited thereto and may be provided at the top or side depending on the battery pack.

The battery cell may be configured such that exhaust gas generated inside the battery cell under abnormal operating conditions, also known as thermal runaway or thermal events, is discharged to the outside of the battery cell. The battery pack or the battery module may include an exhaust port for discharging the exhaust gas to prevent or reduce damage to the battery pack or module by the exhaust gas.

The battery pack may include a battery and a battery management system (BMS) for managing the battery. The battery management system may include a detection device, a balancing device, and a control device. The battery module may include a plurality of cells connected to each other in series and/or parallel. The battery modules may be connected to each other in series and/or in parallel.

The detection device may detect a state of a battery (e.g., voltage, current, temperature, etc.) to output state information indicating the state of the battery. The detection device may detect the voltage of each cell constituting the battery or of each battery module. The detection device may detect current flowing through each battery module constituting the battery module or the battery pack. The detection device may also detect the temperature of a cell and/or module on at least one point of the battery and/or an ambient temperature.

The balancing device may perform a balancing operation of a battery module and/or cells constituting the battery module. The control device may receive state information (e.g., voltage, current, temperature, etc.) of the battery module from the detection device. The control device may monitor and calculate the state of the battery module (e.g., voltage, current, temperature, state of charge (SOC), life span (state of health (SOH)), etc.) on the basis of the state information received from the detection device. In addition, on the basis of the monitored state information, the control device may perform a control function (e.g., temperature control, balancing control, charge/discharge control, etc.) and a protection function (e.g., over-discharge, over-charge, over-current protection, short circuit, fire extinguishing function, etc.). In addition, the control device may perform a wired or wireless communication function with an external device of the battery pack (e.g., a higher level controller or vehicle, charger, power conversion system, etc.).

The control device may control charging/discharging operation and protection operation of the battery. To this end, the control device may include a charge/discharge control unit, a balancing control unit, and/or a protection unit.

The battery management system is a system that monitors the battery state and performs diagnosis and control, communication, and protection functions, and may calculate the charge/discharge state, calculate battery life or state of health (SOH), cut off, as necessary, battery power (e.g., relay control), control thermal management (e.g., cooling, heating, etc.), perform a high-voltage interlock function, and/or may detect and/or calculate insulation and short circuit conditions.

A relay may be a mechanical contactor that is turned on and off by the magnetic force of a coil or a semiconductor switch, such as a metal oxide semiconductor field effect transistor (MOSFET).

The relay control has a function of cutting off the power supply from the battery if (or when) a problem occurs in the vehicle and the battery system and may include one or more relays and pre-charge relays at the positive terminal and the negative terminal, respectively.

In the pre-charge control, there is a risk of inrush current occurring in the high-voltage capacitor on the input side of the inverter when the battery load is connected. Thus, to prevent inrush current when starting a vehicle, the pre-charge relay may be operated before connecting the main relay and the pre-charge resistor may be connected.

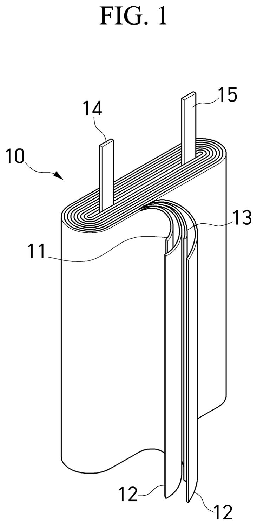

FIG. 1 briefly shows an electrode assembly of a secondary battery.

An electrode assembly 10 may be formed by winding or stacking a stack of a first electrode plate 11, a separator 12, and a second electrode plate 13, which are formed as thin plates or films. When the electrode assembly 10 is a wound stack, a winding axis may be parallel to the longitudinal direction (e.g., the y direction) of the case 51. In other embodiments, the electrode assembly 10 may be a stack type rather than a winding type, and the shape of the electrode assembly 10 is not limited in the present disclosure. In addition, the electrode assembly 10 may be a Z-stack electrode assembly in which a positive electrode plate and a negative electrode plate are inserted into both sides of a separator, which is then bent into a Z-stack. In addition, one or more electrode assemblies may be stacked such that long sides of the electrode assemblies are adjacent to each other and accommodated in the case, and the number of electrode assemblies in the case is not limited in the present disclosure. The first electrode plate 11 of the electrode assembly may act as a negative electrode, and the second electrode plate 13 may act as a positive electrode. Of course, the reverse is also possible.

The first electrode plate 11 may be formed by applying a first electrode active material, such as graphite or carbon, to a first electrode current collector formed of a metal foil, such as copper, a copper alloy, nickel, or a nickel alloy. The first electrode tab 14 may be connected to an external first terminal (not shown). In some embodiments, when the first electrode plate 11 is manufactured, the first electrode tab 14 may be formed by being cut in advance to protrude to one side of the electrode assembly 10, or the first electrode tab 14 may protrude to one side of the electrode assembly 10 more than (e.g., farther than or beyond) the separator 12 without being separately cut.

The second electrode plate 13 may be formed by applying a second electrode active material, such as a transition metal oxide, on a second electrode current collector formed of a metal foil, such as aluminum or an aluminum alloy. The second electrode plate 13 may include a second electrode tab 15 (e.g., a second uncoated portion) that is a region to which the second electrode active material is not applied. The second electrode tab 15 may be connected to an external second terminal (not shown). In some embodiments, the second electrode tab 15 may be formed by being cut in advance to protrude to the other side (e.g., the opposite side) of the electrode assembly 10 when the second electrode plate 13 is manufactured, or the second electrode plate 13 may protrude to the other side of the electrode assembly more than (e.g., farther than or beyond) the separator 12 without being separately cut.

In some example embodiments, the first electrode tab 14 may be located on the left side of the electrode assembly 10, and the second electrode tab 15 may be located on the right side of the electrode assembly 10. In other example embodiments, the first electrode tab 14 and the second electrode tab 15 may be located on one side of the electrode assembly 10 in the same direction.

Here, for convenience of description, the left and right sides are defined according to the electrode assembly 10 as oriented in FIG. 1, and the positions thereof may change when the secondary battery is rotated left and right or up and down.

The separator 12 prevents a short-circuit between the first electrode 11 and the second electrode 13 while allowing movement of lithium ions therebetween. The separator 12 may be made of, for example, a polyethylene film, a polypropylene film, a polyethylene-polypropylene film, or the like.

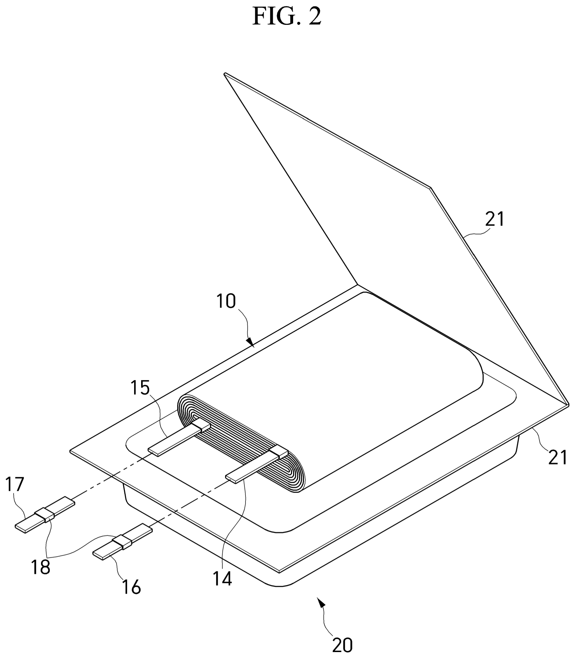

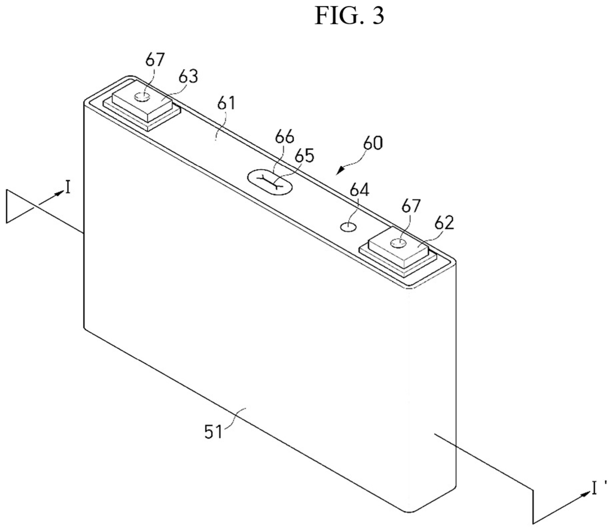

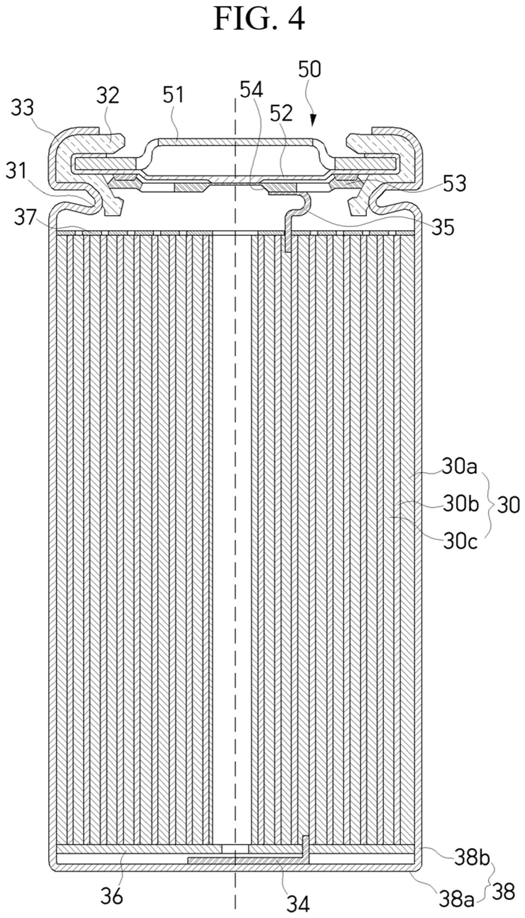

In some embodiments, the electrode assembly 10 may be accommodated in the case (not shown) along with an electrolyte. In the case of a pouch-type secondary battery, an electrode assembly 10 may be accommodated in a pouch made of flexible material in the form illustrated in FIG. 2. In the case of a cylindrical or prismatic secondary battery, an electrode assembly 10 may be accommodated in a cylindrical or prismatic metal casing in the form illustrated in FIGS. 3 and 4.

FIG. 2 schematically illustrates the pouch-type secondary battery.

The pouch-type secondary battery includes an electrode assembly 10 and a pouch 20 that accommodates the electrode assembly 10.

The electrode assembly 10 is the same as that illustrated in FIG. 1. The first electrode tab 14 and the second electrode tab 15 of the electrode assembly 10 may be electrically connected to respective external first and second terminal leads 16 and 17 by welding. Each of the first terminal lead 16 and the second terminal lead 17 may be attached with a tab film 18 for insulation from the pouch 20.

The pouch 20 may be sealed by having sealing parts 21 at the edges thereof come into contact with each other with accommodating the electrode assembly 10 therein, in which case the sealing may be achieved with the tab film 18 interposed between the sealing parts 21. The sealing parts 21 of the pouch 20 may each be made of a thermal fusion material that generally has weak adhesion to metal. Thus, it may be fused to the pouch 20 by interposing the thin tab film 18 between the sealing parts 21.

FIG. 3A is a top perspective view of a prismatic secondary battery.

A case 51 defines an overall appearance of the prismatic secondary battery, and may be made of a conductive metal, such as aluminum, aluminum alloy, or nickel-plated steel. In addition, the case 51 may provide a space for accommodating an electrode assembly therein.

A cap assembly 60 may include a cap plate 61 that covers the opening of the case 59. In some examples, the case 59 and the cap plate 61 may be made of a conductive material. Here, a first terminal 63 and a second terminal 62 may be electrically connected to respective positive and negative (or negative and positive) electrodes inside the case, and may be installed to protrude outward through the cap plate 61.

The cap plate 61 may be equipped with an electrolyte injection port 64 formed to install a sealing plug (or seal pin), and a vent 66 formed with a notch 65. The vent 66 is for discharging gas generated inside the secondary battery.

FIG. 4 is a cross-sectional view of a cylindrical battery;

The secondary battery includes an electrode assembly 30, a case 38 accommodating the electrode assembly 30 and an electrolyte therein, a cap assembly 50 coupled to an opening of the case 38 to seal the case, and an insulating plate 37 positioned between the electrode assembly 30 and the cap assembly 50 inside the case 38.

The electrode assembly 30 may include a separator 30b and a first electrode 30c and a second electrode 30a positioned with the separator interposed therebetween and may be wound in a jelly-roll shape.

The first electrode 30c includes a first substrate and a first active material layer on the first substrate. A first lead tab 35 may extend outwardly from a first uncoated portion of the first substrate at where the first active material layer is not located, and the first lead tab 35 may be electrically connected to the cap assembly 50.

The second electrode 30a includes a second substrate and a second active material layer on the second substrate. A second lead tab 34 may extend outwardly from a second uncoated portion of the second substrate at where the second active material layer is not located, and the second lead tab 34 may be electrically connected to the case 38. The first lead tab 35 and the second lead tab 34 may extend in opposite directions.

The first electrode 30c may act as a positive electrode. In such an embodiment, the first substrate may be made of, for example, an aluminum foil, and the first active material layer may include, for example, a transition metal oxide. The second electrode 30a may act as a negative electrode. In such an embodiment, the second substrate may be made of, for example, a copper foil or a nickel foil, and the second active material layer may include graphite, for example.

The separator 30b prevents a short circuit between the first electrode 30c and the second electrode 30a while allowing movement of lithium ions therebetween. The separator 32b may be made of, for example, a polyethylene film, a polypropylene film, a polyethylene-polypropylene film, or the like.

The case 38 accommodates the electrode assembly 30 and, together with the cap assembly 50, forms the external appearance of the secondary battery. The case 38 may have a substantially cylindrical body portion 38b and a bottom portion 38a connected to one side (e.g., to one end) of the body portion 38b. A beading part 31 (e.g., a bead) deformed inwardly may be formed in the body portion 38b, and a crimping part 33 (e.g., a crimp) bent inwardly may be formed at an open end of the body portion 38b.

The beading part 31 can reduce or prevent movement of the electrode assembly 30 inside the case 38 and can facilitate seating of the gasket 32 and the cap assembly 50. The crimping part 33 may firmly fix the cap assembly 50 by pressing the edge of the case 38 against the gasket 32. The case 38 may be formed of iron plated with nickel, for example.

The cap assembly 50 may be fixed to the inside of the crimping part by a gasket 32 to seal the case 38. The cap assembly 50 may include a cap up 51, a safety vent 52, a cap down 53, an insulating member, and a sub plate 54 but is not limited thereto and may be modified in various ways.

The cap up 51 may be positioned at the uppermost part of the cap assembly 50. The cap up 51 may include a terminal part that protrudes upwardly and is connected to an external circuit, and an outlet for discharging gas may be arranged around the terminal part.

The safety vent 52 may be located under the cap up 51. The safety vent 52 may include a protrusion part that protrudes convexly downwardly and is connected to the sub plate 54, and at least one notch may be formed in the safety vent 52 around the protrusion part.

When gas is generated due to overcharging or abnormal operation of the secondary battery, the protrusion part is deformed upwardly by the pressure and separates from the sub plate 54 while the safety vent 52 is cut (e.g., bursts or tears) along the notch. The cut safety vent 52 may prevent the secondary battery from exploding by allowing for the gas to be discharged to the outside.

The cap down 53 may be below the safety vent 52. The cap down 53 may have a first opening for exposing the protrusion part of the safety vent 52 and a second opening for gas discharge. The insulating member may be positioned between the safety vent 52 and the cap down 53 to insulate the safety vent 52 and the cap down 53.

The sub plate 54 may be under the cap down 53. The sub plate 54 may be fixed to a lower surface of the cap down 53 to block the first opening of the cap down 53, and the protrusion part of the safety vent 52 may be fixed to the sub plate 54. The first lead tab 35, which is drawn out from the electrode assembly 30, may be fixed to the sub plate 54. Accordingly, the cap up 51, the safety vent 52, the cap down 53, and the sub plate 54 may be electrically connected to the first electrode 30c of the electrode assembly 30.

The insulating plate 37 may be positioned to be in contact with the electrode assembly 30 below the beading part 31. The insulating plate 37 may have a tab opening through which the first lead tab 35 is drawn out. The cap assembly 30, which is electrically connected to the first electrode 30c by the first lead tab 35, may face the electrode assembly 30 with an insulating plate 37 interposed therebetween and may maintain a state of being insulated (e.g., electrically insulated) from the electrode assembly 30 by the insulating plate 37. Meanwhile, another insulating plate 36 may be included for insulation between the electrode assembly 30 and the bottom portion 38a of the case 38.

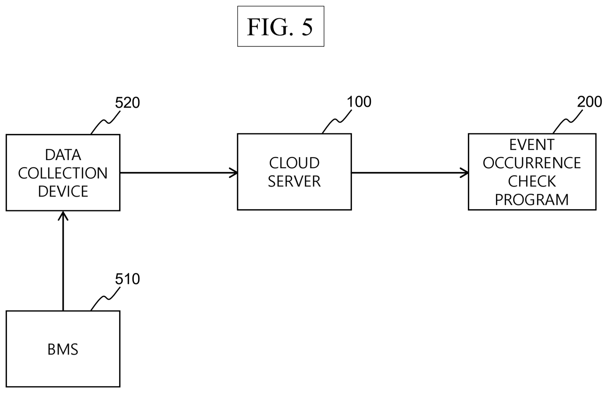

The present disclosure determines whether there is a fire based on the data transmitted to a cloud. FIG. 5 is a conceptual diagram for explaining a method for detecting fire in an ESS or ESSs using cloud services according to the present disclosure. Although the method for detecting fire in ESSs is described below as an example, the present disclosure is also applicable, for example, to detecting fire in a battery pack or battery packs (which may be installed in vehicles or other locations). An ESS may comprise a plurality of racks, with each rack comprising one or more battery packs.

Battery management systems 510 are systems that monitor battery statuses and perform diagnosis and control, communication, and protection functions. The battery management systems 510 transmit battery status data, such as voltage, current, temperature, and alarm/protection occurrence information of individual battery cells, to a data collection device 520. The data collection device 520 transmits the battery status data received from the battery management systems 510 within an ESS to a cloud server 100. An event occurrence check program 200 analyzes the battery status data received from the battery management systems via the cloud server 100 to determine whether there is a fire event. The event occurrence check program 200 may be a program that runs within the cloud server 100 or a program that runs on a processor outside the cloud. A system configured to perform the embodiments described herein may include a computing apparatus that includes the processor outside the cloud that is configured to execute the event occurrence check program 200.

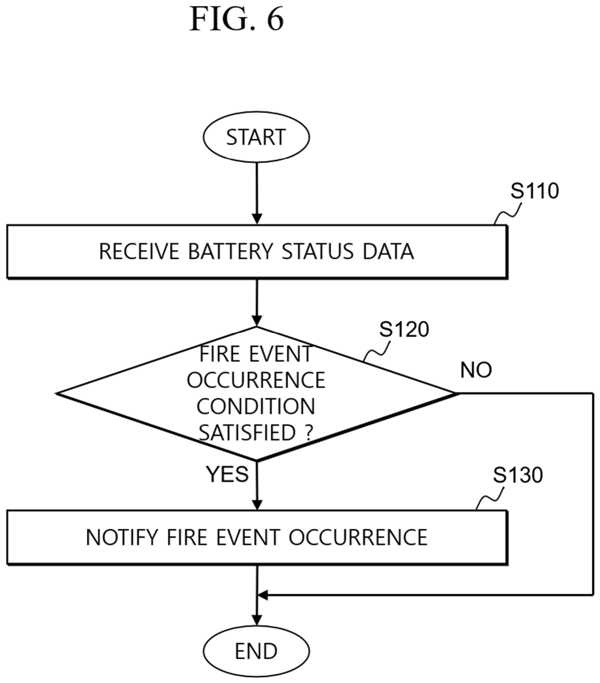

FIG. 6 is a flow diagram illustrating a procedure for determining whether there is a fire event according to an embodiment of the present disclosure. The event occurrence check program 200 receives the battery status data received via the cloud server 100 (S110). The event occurrence check program 200 analyzes the battery status data to determine whether there is a fire (S120). An algorithm for determining whether there is a fire will be described later. The event occurrence check program 200 notifies that a fire event has occurred when it is determined that a fire has occurred (S130). The notification of fire event occurrence may be made by sending a text message, an email, a messenger message, etc. to a predetermined phone number, email address, messenger address, etc.

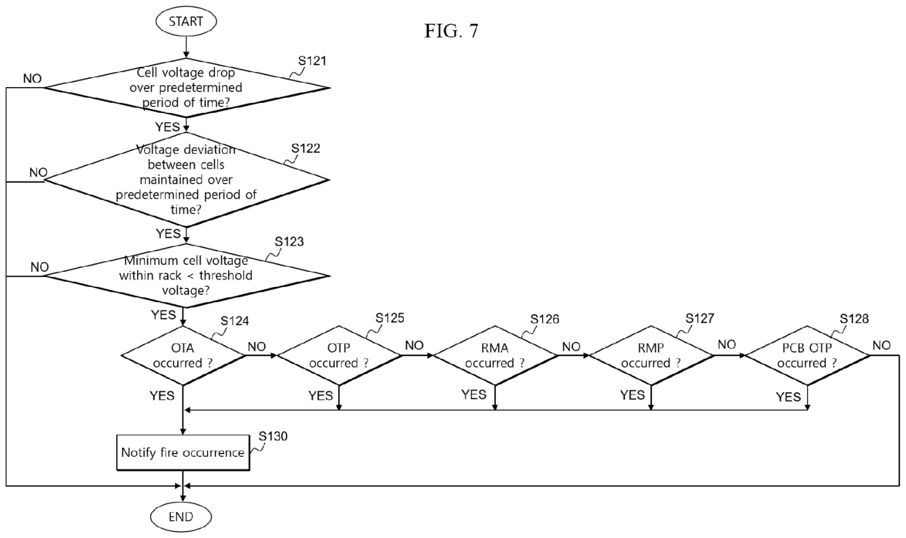

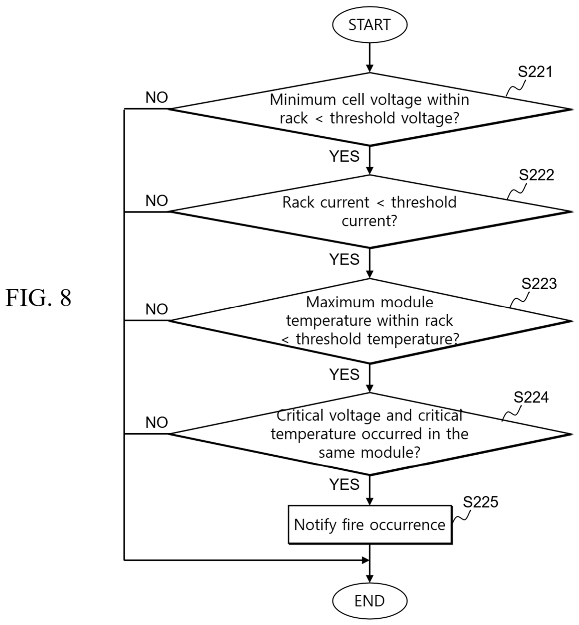

Next, several algorithms for determining whether there is a fire will be described with reference to FIGS. 7 and 8.

If a fire occurs in a battery, some or all of the following phenomena may be observed:
- Cell voltage drop: in the event of fire, a cell voltage drops as the vent of the battery is opened;
- Cell temperature rise: the voltage of the internal temperature sensor of the battery rises due to the fire;
- Module temperature rise: the temperature of the internal module of the battery rises due to the fire; and
- Communication loss: the communication with the module is lost due to explosion caused by the fire.

Since this phenomenon can occur even in cases other than fires, determining events based on individual conditions may result in false detection. For example, if a sensor that detects the voltage of the battery fails, diagnosing events by only observing the cell voltage drop may result in false detection. Therefore, the present disclosure minimizes false detection by synthesizing multiple types of data. In embodiments herein, a method and system is provided in which a determination is made of whether there is a fire based on the simultaneous occurrence of a plurality events, each event being an event that indicates the occurrence or existence of a fire.

The present disclosure uses all or some of the following events to determine whether there is a fire:
- UVP (Under Voltage Protection): a flag that occurs when the cell voltage drops over a predetermined period of time;
- VIMBP (Voltage Imbalance Protection): a flag that occurs when the voltage deviation between cells is maintained over a predetermined period of time;
- OTA/OTP (Over Temperature Alarm/Protection): a flag that occurs when the temperature within the module is maintained above a certain value, indicating when the alarm is generated (OTA) and when the protective action is performed (OTP);
- RMA/RMP (Rack Module Communication Fail Alarm/Protection): a flag that occurs when a communication error occurs between the rack BMS and the module BMS, indicating when the alarm is generated (RMA) and when the protective action is performed (RMP);
- PCB OTP: a flag that occurs when the temperature of the module BMS PCB is maintained above a certain value;
- Current < Cₜₕ: the current measured in the rack is lower than a threshold current Cₜₕ;
- MIN_CV < Vₜₕ: the minimum cell voltage within the rack is lower than a threshold voltage Vₜₕ; and
- MAX_T > Tₜₕ: the maximum module temperature within the rack is higher than a threshold temperature Tₜₕ.

FIG. 7 is a flow diagram illustrating a fire event occurrence determination algorithm according to one embodiment of the present disclosure.

FIG. 7 illustrates that a fire is determined to have occurred when three AND conditions are satisfied and one of five OR conditions is satisfied. The three AND conditions are UVP, VIMBP, and MIN_CV < Vₜₕ, and the five OR conditions are OTA, OTP, RMA, RMP, and PCB OTP. In other words, in FIG. 7, a fire is determined to have occurred in the case of (UVP & VIMBP & (MIN_CV < Vₜₕ) & (OTA | OTP | RMA | RMP | PCB OTP)).

In other words, if the following three AND conditions are all satisfied: the cell voltage drops over a predetermined period of time (step S121); the voltage deviation between cells is maintained over a predetermined period of time (step S122); and the minimum cell voltage within the rack is lower than a threshold voltage Vₜₕ (step S123), and one of the following five OR conditions is satisfied: the alarm that the temperature within the module has been maintained above a certain value (OTA) is generated (step S124); the protective action is performed (OTP) because the temperature within the module has been maintained above a certain value (step S125); the alarm that the communication error has occurred between the rack BMS and the module BMS (RMA) is generated (step S126); the protective action is performed (RMP) because the communication error has occurred between the rack BMS and the module BMS (step S127); and the temperature of the module BMS PCB is maintained above a certain value (PCB OTP) (step S128), the event occurrence check program 200 determines that a fire has occurred in the ESS containing the relevant data and notifies that a fire event has occurred in that ESS (step S130).

The threshold voltage Vₜₕ may be set appropriately depending on the type and installation environment of battery cells and so on. For example, Vₜₕ may be 1 V.

Meanwhile, in some embodiments, it may be determined that a fire event has occurred even if only the three AND conditions are satisfied. In other words, it may be configured to perform only steps S121 to S123 and omit steps S124 to S128.

In addition, in some embodiments, it may be determined that a fire event has occurred if two of the three AND conditions are satisfied. In other words, it may be determined that a fire event has occurred in the following three cases:
UVP & VIMBP;
VIMBP & (MIN_CV < Vₜₕ); and
UVP & (MIN_CV < Vₜₕ).

Moreover, in some embodiments, it may be determined that a fire event has occurred if two of the three AND conditions and one of the OR conditions are satisfied. In other words, it may be determined that a fire event has occurred in the following three cases:
(UVP & VIMBP) & (OTA | OTP | RMA | RMP | PCB OTP);
(VIMBP & (MIN_CV < Vₜₕ)) & (OTA | OTP | RMA | RMP | PCB OTP); and
(UVP & (MIN_CV < Vₜₕ)) & (OTA | OTP | RMA | RMP | PCB OTP).

The UVP, VIMBP, and MIN_CV < Vₜₕ are conditions with a high likelihood of occurring together in the event of occurrence of a fire within a battery pack or in rack of an ESS. Thus, by determining that at least two of these conditions occur at the same time, it is more likely that a fire is occurring and that a fire detection event is accurate and not a false detection. The occurrence of the additional OR conditions are optionally monitored in order to provide improved accuracy on detecting the fire detection event.

Meanwhile, in some embodiments, the event occurrence check program 200 may be configured to accumulate the received data in the cloud and determine a determination factor to be activated/deactivated based on the change in characteristics of the data accumulated in the cloud. The event occurrence check program 200 may also be configured to adjust the priority confirmation order depending on the trend of change in preset data in the confirmation order among determination factors.

FIG. 8 is a flow diagram illustrating a fire event occurrence determination algorithm according to another embodiment of the present disclosure.

FIG. 8 illustrates that a fire is determined to have occurred when four AND conditions are satisfied. The four AND conditions are ((MIN_CV < Vₜₕ) & (Current < Cₜₕ) & (MAX_T > Tₜₕ) & (MIN_CV and MAX_T measured modules are the same)). These four AND conditions are conditions with a high likelihood of occurring together in the event of occurrence of a fire within a battery or rack of an ESS. Thus, by determining that these conditions occur at the same time, it is more likely that a fire is occurring and that a fire detection event is accurate and not a false detection.

In other words, if the minimum cell voltage within the rack is lower than a threshold voltage Vₜₕ (step S221), the current measured in the rack is lower than a threshold current Cₜₕ (step S222), the maximum module temperature within the rack is higher than a threshold temperature Tₜₕ (step S223), and steps S221 and S223 occur in the same module (step S224), the event occurrence check program 200 determines that a fire has occurred in the ESS containing the relevant data and notifies that a fire event has occurred in that ESS (step S130).

The threshold voltage Vₜₕ, the threshold current Cₜₕ, and the threshold temperature Tₜₕ may be set appropriately depending on the type and installation environment of battery cells and so on. For example, Vₜₕ may be 1 V, Cₜₕ may be 2 A, and Tₜₕ may be 40 degrees Celsius.

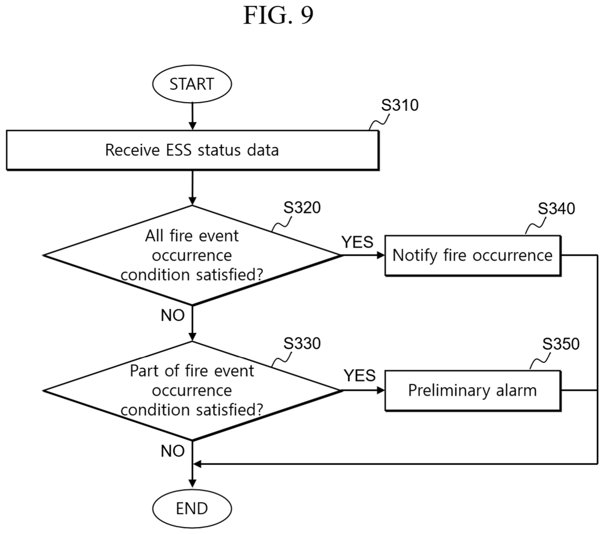

In some embodiments, it may be configured such that the fire alarm level varies with the event that occurs. These embodiments will be described with reference to FIG. 9.

The event occurrence check program 200 receives the battery status data received via the cloud server 100 (S310). The event occurrence check program 200 analyzes the battery status data to determine whether all fire event occurrence conditions are satisfied (S320). Determining whether there is a fire may use the algorithm of FIG. 7 or 8. The event occurrence check program 200 notifies that a fire event has occurred when it is determined that a fire has occurred (S340). The notification of fire event occurrence may be made by sending a text message, an email, a messenger message, etc., notifying that a fire has occurred in a specific ESS, to a predetermined phone number, email address, messenger address, etc. Even if not all the fire event occurrence conditions are satisfied, a preliminary alarm may be issued (S350) if some of the specified conditions are satisfied (S330). The preliminary alarm may be made by sending a text message, an email, a messenger message, etc., notifying that an alarm has preliminarily occurred in a specific ESS, to a predetermined phone number, email address, messenger address, etc.

Determining some of the specified conditions are satisfied comprises determining that at least two, but not all, of the AND conditions are satisfied. Determining some of the specified conditions are satisfied may further comprise one of the OR conditions also being satisfied in addition to the at least two AND conditions. In embodiments, it may be configured to issue a preliminary alarm if two of the three AND conditions in the embodiment of FIG. 7 are satisfied. Alternatively, it may be configured to issue a preliminary alarm if two AND conditions and one OR condition are satisfied. In embodiments, it may be configured to issue a preliminary alarm if three of the four AND conditions in the embodiment of FIG. 8 are satisfied.

Although the method for detecting fire in ESSs has been described above as an example, the present disclosure is also applicable, for example, to detecting fire in battery packs installed in vehicles. In this case, it is possible to accomplish fire detection using the same algorithm by replacing "rack" in the above description with "battery pack".

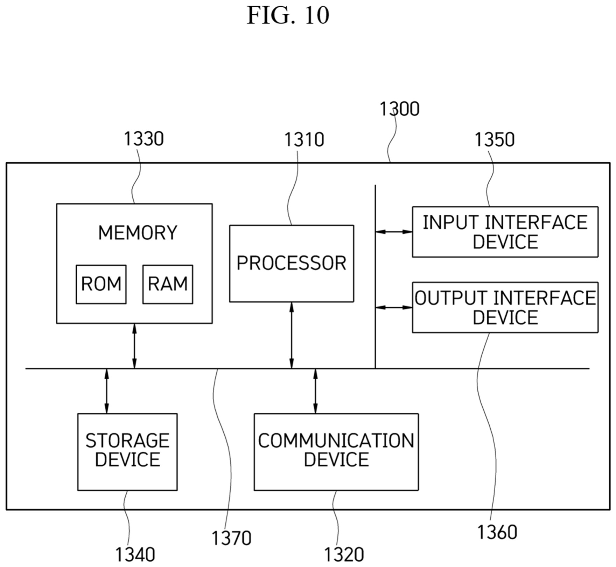

FIG. 10 is a block diagram illustrating a computer system for implementing a method according to an example embodiment of the present disclosure.

Referring to FIG. 10, the computer system 1300 may include at least one of a processor 1310, a memory 1330, an input interface device 1350, an output interface device 1360, and a storage device 1340 communicating with one another through a bus 1370. The computer system 1300 may also include a communication device 1320 coupled to a network. The processor 1310 may be or include a central processing unit (CPU) or a semiconductor device that executes instructions stored in the memory 1330 or in the storage device 1340. The memory 1330 and the storage device 1340 may include various types of volatile or nonvolatile storage media. For example, the memory may include a read-only memory (ROM) and a random access memory (RAM). In example embodiments of the present disclosure, the memory may be located inside or outside the processor, and may be connected to the processor through various known means. The memory is or includes various types of volatile or nonvolatile storage media, and for example, may include a read-only memory (ROM) or a random access memory (RAM).

Accordingly, example embodiments of the present disclosure may be implemented as a method implemented in a computer or a non-transitory computer-readable medium storing computer-executable instructions. In an example embodiment, when executed by the processor, computer-readable instructions may perform a method according to at least one aspect of the present disclosure.

The communication device 1320 may transmit or receive wired signals or wireless signals.

Additionally, the method according to an example embodiment of the present disclosure may be implemented in the form of program instructions that can be executed through various computer means and recorded on a computer-readable medium.

The computer-readable medium may include program instructions, data files, data structures, etc., singly or in combination. The program instructions recorded on the computer-readable medium may be specially designed and configured for the example embodiments of the present disclosure, or may be known and usable by those skilled in the art of computer software. Computer-readable recording media may include a hardware device configured to store and perform program instructions. For example, the computer-readable recording media may be or include magnetic media such as hard disks, floppy disks, and magnetic tapes, optical media such as CD-ROMs and DVDs, magnetooptical media such as floptical disks, ROM, RAM, flash memory, etc. The program instructions may include not only machine language codes such as that generated by a compiler, but also high-level language codes that can be executed by a computer through an interpreter, etc.

The following describes materials that can be used in secondary batteries according to the present invention.

The positive electrode active material may include a compound (lithiated intercalation compound) that is capable of intercalating and deintercalating lithium. Specifically, at least one of a composite oxide of lithium and a metal selected from cobalt, manganese, nickel, and combinations thereof may be used.

The composite oxide may be a lithium transition metal composite oxide. Specific examples of the composite oxide may include lithium nickel-based oxide, lithium cobalt-based oxide, lithium manganese-based oxide, lithium iron phosphate-based compound, cobalt-free nickel-manganese-based oxide, or a combination thereof.

As an example, the following compounds represented by any one of the following Chemical Formulas may be used. LiₐA_{1-b}X_{b}O_{2-c}D_{C} (0.90≤a≤1.8, 0≤b≤0.5, and 0≤c≤0.05); LiₐMn_{2-b}X_{b}O_{4-c}D_{c} (0.90≤a≤1.8, 0≤b≤0.5, and 0≤c≤0.05); LiₐNi_{1-b-c}Co_{b}X_{c}O_{2-α}D_{α} (0.90≤a≤1.8, 0≤b≤0.5, 0≤c≤0.5, and 0<α<2); LiₐNi_{1-b-c}Mn_{b}X_{c}O_{2-α}Dₐ (0.90≤a≤1.8, 0≤b≤0.5, 0≤c≤0.5, and 0<α<2); LiₐNi_{b}Co_{c}L¹_{d}GₑO₂ (0.90≤a≤1.8, 0≤b≤0.9, 0≤c≤0.5, 0≤d≤0.5, and 0≤e≤0.1); LiₐNiG_{b}O₂ (0.90≤a≤1.8 and 0.001≤b≤0.1); LiₐCoG_{b}O₂ (0.90≤a≤1.8 and 0.001≤b≤0.1); LiₐMn_{1-b}G_{b}O₂ (0.90≤a≤1.8 and 0.001≤b≤0.1); LiₐMn₂G_{b}O₄ (0.90≤a≤1.8 and 0.001≤b≤0.1); LiₐMn_{1-g}G_{g}PO₄ (0.90≤a≤1.8 and 0≤g≤0.5); Li_{(3-f)}Fe₂(PO₄)₃ (0≤f≤2); or LiₐFePO₄ (0.90≤a≤1.8).

In the above Chemical Formulas, A is Ni, Co, Mn, or a combination thereof; X is Al, Ni, Co, Mn, Cr, Fe, Mg, Sr, V, a rare earth element or a combination thereof; D is O, F, S, P, or a combination thereof; G is Al, Cr, Mn, Fe, Mg, La, Ce, Sr, V, or a combination thereof; and L1 is Mn, Al, or a combination thereof.

A positive electrode for a rechargeable lithium battery may include a current collector and a positive electrode active material layer on the current collector. The positive electrode active material layer may include a positive electrode active material and may further include a binder and/or a conductive material(e.g., an electrically conductive material).

An amount of the positive electrode active material may be about 90 wt% to about 99.5 wt% based on 100 wt% of the positive electrode active material layer. Amounts of the binder and the conductive material may be about 0.5 wt% to about 5 wt%, respectively, based on 100 wt% of the positive electrode active material layer.

Al may be used as the current collector, but is not limited thereto.

The negative electrode active material may include a material that reversibly intercalates/deintercalates lithium ions, a lithium metal, a lithium metal alloy, a material capable of doping/dedoping lithium, or a transition metal oxide.

The material that reversibly intercalates/deintercalates lithium ions may include a carbon-based negative electrode active material, such as, for example. crystalline carbon, amorphous carbon or a combination thereof. The crystalline carbon may be graphite such as non-shaped, sheet-shaped, flake-shaped, sphere-shaped, or fiber-shaped natural graphite or artificial graphite. The amorphous carbon may be a soft carbon, a hard carbon, a mesophase pitch carbonization product, calcined coke, and the like.

The material capable of doping/dedoping lithium may be a Si-based negative electrode active material or a Sn-based negative electrode active material. The Si-based negative electrode active material may include silicon, a silicon-carbon composite, SiOx (0 < x < 2), a Si-Q alloy and a combination thereof.

The silicon-carbon composite may be a composite of silicon and amorphous carbon. According to an embodiment, the silicon-carbon composite may be in a form of silicon particles and amorphous carbon coated on the surface of the silicon particles.

The silicon-carbon composite may further include crystalline carbon. For example, the silicon-carbon composite may include a core including crystalline carbon and silicon particles and an amorphous carbon coating layer on a surface of the core.

The negative electrode for a rechargeable lithium battery may include a current collector and a negative electrode active material layer on the current collector. The negative electrode active material layer may include a negative electrode active material, and may further include a binder and/or a conductive material (e.g., an electrically conductive material).

For example, the negative electrode active material layer may include about 90 wt% to about 99 wt% of the negative electrode active material, about 0.5 wt% to about 5 wt% of the binder, and about 0 wt% to about 5 wt% of the conductive material.

The binder may serve to attach the negative electrode active material particles well to each other and also to attach the negative electrode active material well to the current collector. The binder may include a non-aqueous binder, an aqueous binder, a dry binder, or a combination thereof.

The negative current collector may include a copper foil, a nickel foil, a stainless steel foil, a titanium foil, a nickel foam, a copper foam, a polymer substrate coated with a conductive metal, or a combination thereof.

The electrolyte solution for a rechargeable lithium battery may include a non-aqueous organic solvent and a lithium salt.

The non-aqueous organic solvent may serve as a medium for transmitting ions taking part in the electrochemical reaction of a battery.

The non-aqueous organic solvent may be a carbonate-based, ester-based, ether-based, ketone-based, or alcohol-based solvent, an aprotic solvent, or a combination thereof.

In addition, when using a carbonate-based solvent, a cyclic carbonate and a chain carbonate may be mixed and used.

Depending on the type of the rechargeable lithium battery, a separator may be present between the positive electrode and the negative electrode. The separator may include polyethylene, polypropylene, polyvinylidene fluoride, or a multilayer film of two or more layers thereof.

The separator may include a porous substrate and a coating layer including an organic material, an inorganic material, or a combination thereof on one or both surfaces of the porous substrate.

The organic material may include a polyvinylidene fluoride-based polymer or a (meth)acrylic polymer.

The inorganic material may include inorganic particles selected from Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and a combination thereof, but is not limited thereto.

The organic material and the inorganic material may be mixed in one coating layer, or a coating layer including an organic material and a coating layer including an inorganic material may be stacked.

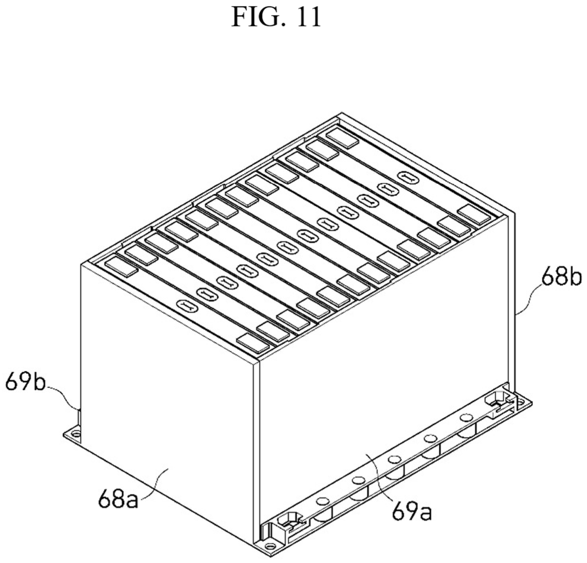

FIG. 11 is an example diagram illustrating a secondary battery module in which cylindrical tabless secondary battery cells of the present disclosure are disposed. According to the increase in secondary battery capacity for driving electric vehicles, a plurality of secondary battery cells may be put into a module case of a predetermined shape and disposed and connected in a horizontal direction and/or a vertical direction to manufacture a secondary battery module. A plurality of secondary batteries are arranged in the space formed by a pair of opposing end plates (68a, 68b) and a pair of opposing side plates (69a, 69b). The arrangement of the secondary batteries can be designed in terms of the arrangement direction and number to obtain the desired voltage and current specifications.

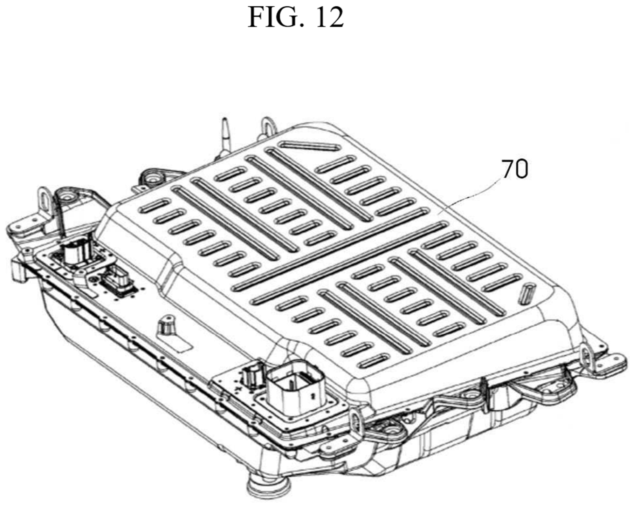

FIG. 12 is an example diagram illustrating a secondary battery pack 70 formed to apply the secondary battery module shown in FIG. 11 to an actual product (e.g., a vehicle). The secondary battery pack may be manufactured by embedding a plurality of secondary battery modules into a pack housing designed to be mounted in an actual product. The pack housing may include fasteners and electrical outlets necessary for mounting to the product. In FIG. 12, for convenience of illustration, related elements such as bus bars for electrical connection of the secondary batteries, cooling units, and external terminals are omitted.

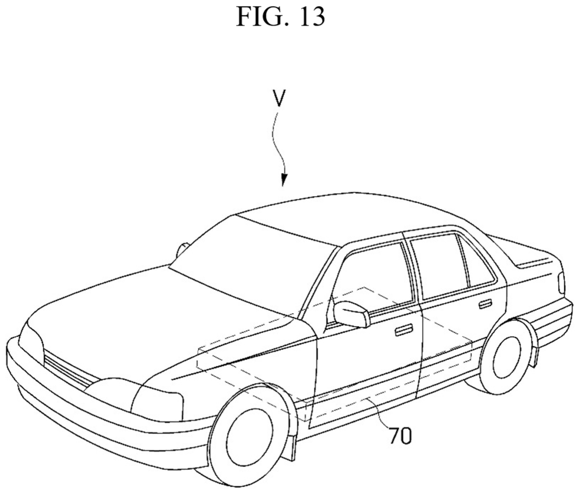

The secondary battery pack may be mounted on a vehicle. The vehicle may be, for example, an electric vehicle, a hybrid vehicle, or a plug-in hybrid vehicle. The vehicle may include a four-wheel drive or two-wheel drive vehicle. FIG. 13 is a diagram for describing a vehicle including the secondary battery pack shown in FIG. 12. FIG. 13 illustrates the secondary battery pack 70 according to one embodiment of the present disclosure mounted on a lower portion of a vehicle body of a vehicle. The vehicle operates by receiving power from the secondary battery pack 70 according to one embodiment of the present disclosure.

As is apparent from the above description, according to the present disclosure, it is possible to detect whether a fire has occurred in the ESS or the battery pack without installing a separate fire sensor in the ESS or the battery pack. Since data is mostly received within a short period of time in the cloud system, it is possible to recognize the occurrence of fire in the early stages thereof and allow for response accordingly. In addition, it is possible to appropriately set the conditions for determining fire occurrence in cloud data depending on the type and installation environment of batteries and so on, allowing for response to various environments and needs.

However, effects of the present disclosure which may be obtained in the present disclosure are not limited to the aforementioned effects, and other effects not described above may be evidently understood by those skilled in the art from the following description.

Although the present disclosure has been described above with respect to embodiments thereof, the present disclosure is not limited thereto. Various modifications and variations can be made by those skilled in the art within the scope of the present disclosure and the scope of equivalence of the appended claims.

Further Embodiments are set out in the following clauses:
Clause 1. A method for detecting fire in ESSs, comprising:
   receiving battery status data from battery management systems via a server; and
   analyzing the received battery status data to determine whether a fire occurs.
Clause 2. The method according to clause 1, wherein in the analyzing the received battery status data, it is determined that the fire occurs if a cell voltage drops over a predetermined period of time, a voltage deviation between cells is maintained over a predetermined period of time, and a minimum cell voltage within a rack is lower than a threshold voltage.
Clause 3. The method according to clause 1, wherein in the analyzing the received battery status data, it is determined that the fire occurs if the following three conditions are all satisfied: a cell voltage drops over a predetermined period of time; a voltage deviation between cells is maintained over a predetermined period of time; and a minimum cell voltage within a rack is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a rack BMS and a module BMS is generated; a protective action is performed because the communication error occurs between the rack BMS and the module BMS; and a module BMS PCB temperature is maintained above a certain value.
Clause 4. The method according to clause 1, wherein in the analyzing the received battery status data, it is determined that the fire occurs if at least two of the following three conditions are satisfied: a cell voltage drops over a predetermined period of time, a voltage deviation between cells is maintained over a predetermined period of time, and a minimum cell voltage within a rack is lower than a threshold voltage.
Clause 5. The method according to clause 1, wherein in the analyzing the received battery status data, it is determined that the fire occurs if at least two of the following three conditions are satisfied: a cell voltage drops over a predetermined period of time; a voltage deviation between cells is maintained over a predetermined period of time; and a minimum cell voltage within a rack is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a rack BMS and a module BMS is generated; a protective action is performed because the communication error occurs between the rack BMS and the module BMS; and a module BMS PCB temperature is maintained above a certain value.
Clause 6. The method according to clause 1, wherein in the analyzing the received battery status data, it is determined that the fire occurs if a minimum cell voltage within a rack is lower than a threshold voltage, a current measured in the rack is lower than a threshold current, a maximum module temperature within the rack is higher than a threshold temperature, and the minimum cell voltage within the rack being lower than the threshold voltage and the maximum module temperature within the rack being higher than the threshold temperature occur in the same module.
Clause 7. The method according to any preceding clause, further comprising notifying that a fire event occurs if it is determined that the fire occurs.
Clause 8. The method according to any preceding clause, wherein the server is a cloud server.
Clause 9. A method for detecting fire in battery packs, comprising:
   receiving battery status data from battery management systems via a server; and
   analyzing the received battery status data to determine whether a fire occurs.
Clause 10. The method according to clause 9, wherein in the analyzing the received battery status data, it is determined that the fire occurs if a cell voltage drops over a predetermined period of time, a voltage deviation between cells is maintained over a predetermined period of time, and a minimum cell voltage within a battery pack is lower than a threshold voltage.
Clause 11. The method according to clause 9, wherein in the analyzing the received battery status data, it is determined that the fire occurs if the following three conditions are all satisfied: a cell voltage drops over a predetermined period of time; a voltage deviation between cells is maintained over a predetermined period of time; and a minimum cell voltage within a battery pack is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a battery pack BMS and a module BMS is generated; a protective action is performed because the communication error occurs between the battery pack BMS and the module BMS; and a module BMS PCB temperature is maintained above a certain value.
Clause 12. The method according to clause 9, wherein in the analyzing the received battery status data, it is determined that the fire occurs if at least two of the following three conditions are satisfied: a cell voltage drops over a predetermined period of time, a voltage deviation between cells is maintained over a predetermined period of time, and a minimum cell voltage within a battery pack is lower than a threshold voltage.
Clause 13. The method according to clause 9, wherein in the analyzing the received battery status data, it is determined that the fire occurs if at least two of the following three conditions are satisfied: a cell voltage drops over a predetermined period of time; a voltage deviation between cells is maintained over a predetermined period of time; and a minimum cell voltage within a battery pack is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a battery pack BMS and a module BMS is generated; a protective action is performed because the communication error occurs between the battery pack BMS and the module BMS; and a module BMS PCB temperature is maintained above a certain value.
Clause 14. The method according to clause 9, wherein in the analyzing the received battery status data, it is determined that the fire occurs if a minimum cell voltage within a battery pack is lower than a threshold voltage, a current measured in the battery pack is lower than a threshold current, a maximum module temperature within the battery pack is higher than a threshold temperature, and the minimum cell voltage within the battery pack being lower than the threshold voltage and the maximum module temperature within the battery pack being higher than the threshold temperature occur in the same module.
Clause 15. The method according to any one of clauses 9 - 14, further comprising notifying that a fire event occurs if it is determined that the fire occurs.

## Claims

1. A method for detecting fire in an Energy Storage System, hereafter ESS, or for detecting fire in a battery pack, comprising:
receiving battery status data from battery management systems via a server; and
analyzing the received battery status data to determine whether a fire occurs.

2. The method as claimed in claim 1, wherein in the analyzing the received battery status data, it is determined that the fire occurs if a cell voltage drops over a predetermined period of time, a voltage deviation between cells is maintained over a predetermined period of time, and a minimum cell voltage within a rack of the ESS is lower than a threshold voltage.

3. The method as claimed in claim 1, wherein in the analyzing the received battery status data, it is determined that the fire occurs if the following three conditions are all satisfied: a cell voltage drops over a predetermined period of time; a voltage deviation between cells is maintained over a predetermined period of time; and a minimum cell voltage within a rack of the ESS is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a rack BMS and a module BMS is generated; a protective action is performed because the communication error occurs between the rack BMS and the module BMS; and a module BMS PCB temperature is maintained above a certain value.

4. The method as claimed in claim 1, wherein in the analyzing the received battery status data, it is determined that the fire occurs if at least two of the following three conditions are satisfied: a cell voltage drops over a predetermined period of time, a voltage deviation between cells is maintained over a predetermined period of time, and a minimum cell voltage within a rack of the ESS is lower than a threshold voltage.

5. The method as claimed in claim 1, wherein in the analyzing the received battery status data, it is determined that the fire occurs if at least two of the following three conditions are satisfied: a cell voltage drops over a predetermined period of time; a voltage deviation between cells is maintained over a predetermined period of time; and a minimum cell voltage within a rack of the ESS is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a rack BMS and a module BMS is generated; a protective action is performed because the communication error occurs between the rack BMS and the module BMS; and a module BMS PCB temperature is maintained above a certain value.

6. The method as claimed in claim 1, wherein in the analyzing the received battery status data, it is determined that the fire occurs if a minimum cell voltage within a rack of the ESS is lower than a threshold voltage, a current measured in the rack is lower than a threshold current, a maximum module temperature within the rack is higher than a threshold temperature, and the minimum cell voltage within the rack being lower than the threshold voltage and the maximum module temperature within the rack being higher than the threshold temperature occur in the same module.

7. The method as claimed in claim 1, wherein in the analyzing the received battery status data, it is determined that the fire occurs if a cell voltage drops over a predetermined period of time, a voltage deviation between cells is maintained over a predetermined period of time, and a minimum cell voltage within the battery pack is lower than a threshold voltage.

8. The method as claimed in claim 1, wherein in the analyzing the received battery status data, it is determined that the fire occurs if the following three conditions are all satisfied: a cell voltage drops over a predetermined period of time; a voltage deviation between cells is maintained over a predetermined period of time; and a minimum cell voltage within the battery pack is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a battery pack BMS and a module BMS is generated; a protective action is performed because the communication error occurs between the battery pack BMS and the module BMS; and a module BMS PCB temperature is maintained above a certain value.

9. The method as claimed in claim 1, wherein in the analyzing the received battery status data, it is determined that the fire occurs if at least two of the following three conditions are satisfied: a cell voltage drops over a predetermined period of time, a voltage deviation between cells is maintained over a predetermined period of time, and a minimum cell voltage within the battery pack is lower than a threshold voltage.

10. The method as claimed in claim 1, wherein in the analyzing the received battery status data, it is determined that the fire occurs if at least two of the following three conditions are satisfied: a cell voltage drops over a predetermined period of time; a voltage deviation between cells is maintained over a predetermined period of time; and a minimum cell voltage within the battery pack is lower than a threshold voltage, and at least one of the following five conditions is satisfied: an alarm that an in-module temperature is maintained above a certain value is generated; a protective action is performed because the in-module temperature is maintained above the certain value; an alarm that a communication error occurs between a battery pack BMS and a module BMS is generated; a protective action is performed because the communication error occurs between the battery pack BMS and the module BMS; and a module BMS PCB temperature is maintained above a certain value.

11. The method as claimed in claim 1, wherein in the analyzing the received battery status data, it is determined that the fire occurs if a minimum cell voltage within the battery pack is lower than a threshold voltage, a current measured in the battery pack is lower than a threshold current, a maximum module temperature within the battery pack is higher than a threshold temperature, and the minimum cell voltage within the battery pack being lower than the threshold voltage and the maximum module temperature within the battery pack being higher than the threshold temperature occur in the same module.

12. The method as claimed in any preceding claim, further comprising notifying that a fire event occurs if it is determined that the fire occurs.

13. The method as claimed in any preceding claim, wherein the server is a cloud server.

14. A system configured to perform the method according to any preceding claim.
